(19) Europäisches Patentamt / European Patent Office / Office européen des brevets

(11) **EP 4 502 241 A2**

(12) **EUROPEAN PATENT APPLICATION**

(43) Date of publication:
**05.02.2025 Bulletin 2025/06**

(21) Application number: **24163201.7**

(22) Date of filing: **13.03.2024**

(51) International Patent Classification (IPC):
**C25B 15/023** (2021.01)   **C25B 9/77** (2021.01)
**G06F 30/20** (2020.01)   **C25B 1/04** (2021.01)
**C25B 1/23** (2021.01)   **C25B 3/26** (2021.01)

(52) Cooperative Patent Classification (CPC):
**C25B 9/77; C25B 15/023; G06F 30/20;** C25B 1/04;
C25B 1/23; C25B 3/26

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **02.08.2023 JP 2023126035**

(71) Applicant: **Kabushiki Kaisha Toshiba**
**Tokyo 105-0023 (JP)**

(72) Inventors:
• **FUJIWARA, Naoya**
**Tokyo, 105-0023 (JP)**

• **YAMAGIWA, Masakazu**
**Tokyo, 105-0023 (JP)**
• **KITAGAWA, Ryota**
**Tokyo, 105-0023 (JP)**
• **KOFUJI, Yusuke**
**Tokyo, 105-0023 (JP)**
• **MIKOSHIBA, Satoshi**
**Tokyo, 105-0023 (JP)**
• **KUDO, Yuki**
**Tokyo, 105-0023 (JP)**

(74) Representative: **Hoffmann Eitle**
**Patent- und Rechtsanwälte PartmbB**
**Arabellastraße 30**
**81925 München (DE)**

(54) **ELECTROLYSIS DEVICE SIMULATOR, SIMULATION METHOD, AND ELECTROLYSIS DEVICE**

(57)    A simulator of an embodiment is an electrolysis device simulator configured to simulate, by computation, the performance of a first electrolysis cell stack including one or more electrolysis cells each including a cathode configured to perform a reduction reaction and an anode configured to perform an oxidation reaction. It includes an arithmetic unit configured to perform an arithmetic operation using a first variable group representing at least one of flooding and salt precipitation in the first electrolysis cell stack, in a computational algorithm implemented in the simulator of the embodiment.

FIG. 1

EP 4 502 241 A2

## Description

FIELD

Embodiments disclosed herein relate to an electrolysis device simulator, a simulation method, and an electrolysis device.

BACKGROUND

Lately, there has been a concern about the depletion of fossil fuels such as petroleum and coal, and expectations are increasing for sustainably available renewable energy. Examples of renewable energy include those by solar power generation, hydroelectric power generation, wind power generation, and geothermal power generation. The amount of powers generated by these depends on weather, nature's conditions, and so on, and thus they are variable power sources and have a problem of difficulty in stably supplying the power. In light of this, it has been attempted to store, in a storage battery, the power generated from renewable energy, to stabilize the power supply. Storing the power, however, has problems of the cost of the storage battery and the occurrence of loss during the power storage.

What is gaining attention under such circumstances is a technique that converts electric energy into a chemical substance (chemical energy) such as a technique that, by using power generated from renewable energy, electrolyzes water to produce hydrogen from the water, electrochemically reduces carbon dioxide to produce a carbon compound such as carbon monoxide, formic acid, methanol, methane, acetic acid, ethanol, ethane, or ethylene, or electrochemically reduces nitrogen to produce ammonia. Storing these chemical substances in a cylinder or a tank has the advantages of being lower in energy storage cost and smaller in storage loss than storing the power (electric energy) in the storage battery.

The above-described electrolysis of water ($H_2O$), carbon dioxide ($CO_2$), nitrogen ($N_2$), or the like is often executed in an electrolysis cell or an electrolysis cell stack composed of a stack of a plurality of electrolysis cells. In the electrolysis cell stack, there is a problem that phenomena such as flooding and salt precipitation occur, causing its performance degradation. For example, in a $CO_2$ electrolysis cell whose anode is supplied with an electrolytic solution and whose cathode is supplied with carbon dioxide, the electrolytic solution may move from the anode side to the cathode side. The electrolytic solution which has moved to the cathode side inhibits the carbon dioxide from reaching a reaction site of a catalyst surface of the cathode to cause the performance degradation of the electrolysis cell. This has given rise to a demand for a technique for predicting the performance of a cell stack in consideration of the phenomena such as flooding and salt precipitation, and a technique capable of controlling the cell stack so that flooding and salt precipitation can be suppressed.

SUMMARY

A problem to be solved by embodiments of the present invention is to provide an electrolysis device simulator enabling the determination of a state close to the actual operation of an electrolysis cell or an electrolysis cell stack, a simulation method, and an electrolysis device including such a simulator.

According to the embodiments of the present invention, there are provided an electrolysis device simulator enabling the determination of a state close to the actual operation of an electrolysis cell or an electrolysis cell stack, a simulation method, and an electrolysis device including such a simulator.

BRIEF DESCRIPTION OF THE DRAWINGS

FIG. 1 is a diagram illustrating a first example of a simulator of an embodiment.

FIG. 2 is a diagram illustrating an example of an electrolysis device of which the simulator of the embodiment simulates performance by computation.

FIG. 3 is a diagram illustrating a second example of the simulator of the embodiment.

FIG. 4 is a diagram illustrating a third example of the simulator of the embodiment.

FIG. 5 is a diagram illustrating a fourth example of the simulator of the embodiment.

FIG. 6 is a diagram illustrating a fifth example of the simulator of the embodiment.

FIG. 7 is a chart schematically illustrating a temporal variation in light intensity in a cathode channel, as one variable of a first variable group of the simulator of the embodiment.

FIG. 8 is a chart illustrating an example of an analysis of the result of X-ray imaging of a cross section of an electrolysis cell, as one variable of the first variable group of the simulator of the embodiment.

FIG. 9 is a chart illustrating an example of an analysis of the result of X-ray imaging of a cathode cross section under a varied current density applied to the electrolysis cell, as one variable of the first variable group of the simulator of the embodiment.

FIG. 10 is a diagram illustrating an example of the electrolysis device of the embodiment.

FIG. 11 is a diagram illustrating another example of the electrolysis device of the embodiment.

FIG. 12 is a conceptual chart of the simulator of the embodiment.

FIG. 13 is a first flowchart in a control method of the electrolysis device of the embodiment.

FIG. 14 is a second flowchart in the control method of the electrolysis device of the embodiment.

DETAILED DESCRIPTION

An electrolysis device simulator of an embodiment includes: an arithmetic unit configured to simulate, by computation, performance of a first electrolysis cell stack including one or more electrolysis cells each including a cathode configured to perform a reduction reaction and an anode configured to perform an oxidation reaction. The arithmetic unit in the simulator of the embodiment is configured to perform an arithmetic operation using a first variable group representing at least one of flooding and salt precipitation in the first electrolysis cell stack.

The electrolysis device simulator of the embodiment, a simulation method, and an electrolysis device including such a simulator will be hereinafter described with reference to the drawings. In the embodiment described below, substantially the same constituent parts are denoted by the same reference signs, and a description thereof may be partly omitted. The drawings are schematic, and the thickness-planar size relation, a thickness ratio among parts, and so on may be different from actual ones.

The electrolysis device to be simulated by the simulator of the embodiment includes a first cell stack including one or more electrolysis cells each including a cathode configured to perform a reduction reaction and an anode configured to perform an oxidation reaction. As for the first cell stack to be simulated, its size and the number of electrolysis cells stacked therein may be any. Typically, one whose electrode area is several $cm^2$ to several thousand $cm^2$ and in which the number of the stacked electrolysis cells is 1 (unit cell) to several 100 is often dealt with.

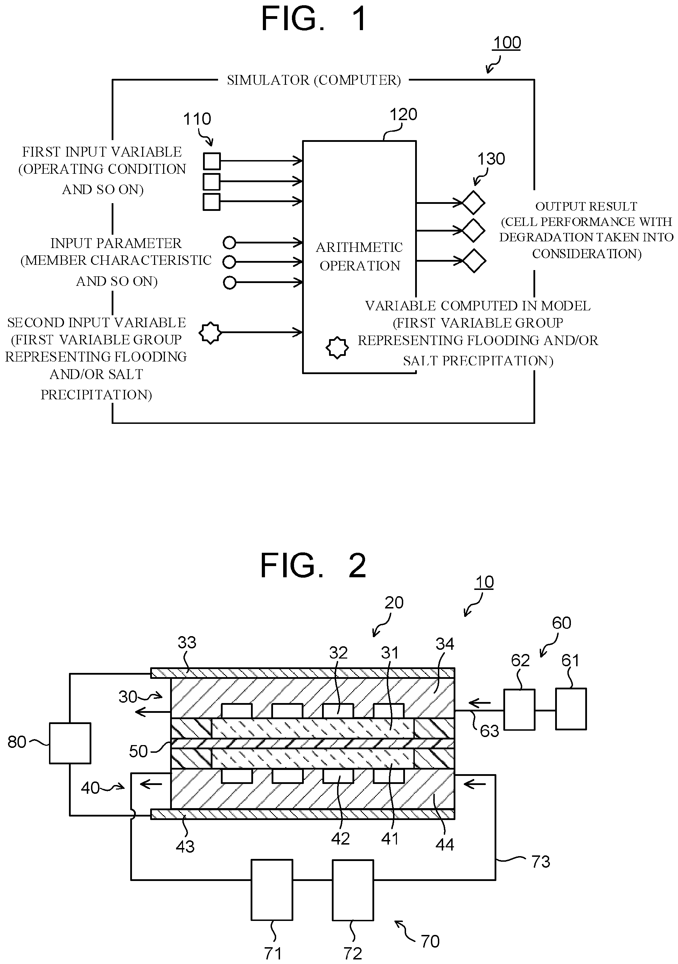

FIG. 1 is a diagram illustrating a first example of a simulator 100 of the embodiment. As illustrated in FIG. 1, the simulator 100 of the embodiment is a computer in which a simulation model (computational algorithm) is implemented. The model includes an input unit 110, an arithmetic unit 120, and an output unit 130. To the input unit 110, variables (first input variables) reflecting the operating states of the first cell stack, such as temperature, pressure, and current density and parameters not dependent on the operating states, such as the thickness and porosity of a component of the cell and a coefficient representing the properties of a catalyst material, are input, for instance. Based on these inputs, an arithmetic operation is performed.

In particular, the arithmetic operation may be one using an analytic equation, may be one using a numerical solution, or may be one using machine learning. It may also be a multiphysics model in which computations or the like of material balance or energy balance, a chemical reaction rate, and overvoltage are coupled. These arithmetic operations may be those involving convergence computation. Outputs obtained as the results of the arithmetic operations indicate the performance of the first cell stack. Examples of the output include a current-voltage characteristic, selectivity of a product, and Faraday efficiency, but it is not limited to any of these.

The simulator 100 of the embodiment is characterized by using a first variable group representing at least one of flooding and salt precipitation in the first electrolysis cell stack. The first variable group is composed of one variable or more. The variable of the first variable group may be an input to the arithmetic operation, may be one indirectly computed in the arithmetic operation from another variable, or may be both of these. To the input unit 110 of the simulator 100 illustrated in FIG. 1, a second input variable composed of all or some of the variables forming the first variable group is input in addition to the first input variables reflecting the operating state of the first electrolysis cell stack and the parameters not dependent on the operating state.

The variables of the first variable group can be selected from the composition, mass, volume, and density of a solution or a solid in the interior of the first electrolysis cell stack, for example, in a specific area of an anode channel, an anode, a membrane, a cathode, or a cathode channel, their temporal and spatial variations, and those resulting from the nondimensionalization of these quantities. Further, in a stack including a plurality of electrolysis cells, the statistic (for example, the average, standard deviation, or the like) of each of the aforesaid quantities in the cells in the stack is also adoptable as the variable of the first variable group. Examples of the temporal and spatial variations include the accumulation and lost amounts of a solution or a solid in an area of interest inside the cell, a flux exiting from/entering the aforesaid area, and so on. Examples of the nondimensionalized quantities include a ratio of a liquid occupying the volume of the cathode channel, and a normalized flux of a solution flowing in at a given position in the cathode, by a value that it has at the start of the electrolysis.

FIG. 2 illustrates a carbon dioxide ($CO_2$) electrolysis cell stack 10 as an example of the electrolysis device in which the simulator 100 of the embodiment simulates the performance by computation. The electrolysis cell stack 10 illustrated in FIG. 2 includes electrolysis cells 20. Though FIG. 2 illustrates only one electrolysis cell (unit cell) 20, but one in which the number of the unit cells 20 stacked is up to about several 100 is usable as the electrolysis cell stack 10. Here, the single electrolysis cell 20 and the stack in which a required number of these are stacked will be both called the electrolysis cell stack 10. The electrolysis cell 20 includes a cathode part 30, an anode part 40, and a separator (membrane) 50.

The cathode part 30 includes a reduction electrode (cathode) 31 having a metal catalyst layer, a cathode channel 32, and a cathode current collector 33. The cathode channel 32 is a gas channel through which a $CO_2$ gas as a reducible gas is supplied to the cathode 31. The cathode 31 is arranged to be in contact with $CO_2$ flowing in the cathode channel 32. The anode part 40 includes an anode (oxidation electrode) 41, an anode channel 42, and an anode current collector 43. The anode channel 42 is an electrolytic solution channel through which an electrolytic solution as an anolyte is supplied to the anode 41. The electrolytic solution contains water ($H_2O$) or hydroxide ions ($OH^-$) as an oxidizable material. The anode 41 is arranged to be in contact with the anolyte flowing in the anode channel 42.

The electrolysis cell stack 10 includes a gas supply part 60 that supplies $CO_2$ to the electrolysis cell 20 and an anolyte supply part (supply system) 70 that supplies the anolyte to the electrolysis cell 20. The gas supply part 60 includes a $CO_2$ storage part 61 such as a $CO_2$ gas cylinder and a $CO_2$ adjusting part 62 that adjusts the flow rate of the $CO_2$ gas, and supplies the $CO_2$ gas from the $CO_2$ storage part 61 to the cathode channel 32 through a gas pipe 63. The cathode 31 of the electrolysis cell 20 illustrated in FIG. 2 is supplied with ions through the separator 50 and is supplied with the $CO_2$ gas through the cathode channel 32. A $CO_2$ reduction product is discharged mainly from the cathode channel 32. The anolyte supply part 70 includes an anolyte tank 71 and a pump 72 and supplies the anolyte from the anolyte tank 71 to the anode channel 42 through the pump 72 and an electrolytic solution pipe 73. The anolyte circulates in the anode channel 42 and the electrolytic solution pipe 73.

The electrolysis cell 20 is typically sandwiched by a pair of support plates (not illustrated) and is further fastened with bolts or the like. The cathode current collector 33 and the anode current collector 43 are connected to a power source 80. The power source 80 is not limited to an ordinary commercial power source, battery, or the like and may be a power source that converts renewable energy into electric energy to supply it. Examples of such a power source include a power source that converts kinetic energy or potential energy such as wind power, water power, geothermal power, or tidal power into electric energy, a power source such as a solar battery having a photoelectric conversion element that converts light energy into electric energy, a power source such as a fuel cell or a storage battery that converts chemical energy into electric energy, and a power source such as a device that converts vibration energy such as sound into electric energy.

The cathode 31 is an electrode (reduction electrode) that causes a reduction reaction of carbon dioxide ($CO_2$) which is the reducible gas, to produce a carbon compound such as carbon monoxide (CO), methane ($CH_4$), ethane ($C_2H_6$), ethylene ($C_2H_4$), methanol ($CH_3OH$), ethanol ($C_2H_5OH$), or ethylene glycol ($C_2H_6O_2$). In the cathode 31, simultaneously with the reduction reaction of the carbon dioxide ($CO_2$), a side reaction in which hydrogen ($H_2$) is produced through a reduction reaction of water ($H_2O$) may occur. In such a cathode part 30, the $CO_2$ gas from the gas supply part 60 is introduced through a gas inlet port of the cathode channel 32. Further, a reaction product gas containing CO, $H_2$, and so on is discharged through a gas discharge port, and the discharged gas is sent to a not-illustrated valuables production part or collected in a product collecting part.

The cathode 31 has a structure that allows a gas and a liquid to move between the separator 50 and the cathode channel 32, for example, a porous structure such as a mesh material, a punched material, a porous body, or a metal fiber sintered body. The cathode 31 includes, for example, a porous base containing carbon fibers and a cathode catalyst layer provided on the porous base. Between the porous base and the cathode catalyst layer, a porous layer denser than the porous base may be arranged. The porous base is arranged on the cathode channel 32 side and the cathode catalyst layer is arranged on the separator 50 side. The cathode catalyst layer may penetrate into the porous base. The cathode catalyst layer of the cathode 31 preferably has catalyst nanoparticles, a catalyst nanostructure, or the like. The cathode catalyst layer is preferably formed of a catalyst material (cathode catalyst material) capable of reducing $CO_2$ to produce a carbon compound and capable of decreasing the overvoltage of such a reaction.

The anode 41 is an electrode (oxidation electrode) that causes an oxidation reaction of water ($H_2O$) in the anolyte to produce oxygen ($O_2$) and hydrogen ions ($H^+$) or causes an oxidation reaction of the hydroxide ions ($OH^-$) produced in the cathode part 30 to produce oxygen and water. In the anode part 40, the anolyte is introduced and discharged through a solution inlet port and a solution outlet port of the anode channel 42 using the pump 72. The anolyte flows in the anode channel 42 while coming into contact with the anode 41. In the case where the anolyte is an aqueous solution of an electrolyte, the anode 41 is preferably formed mainly of a catalyst material (anode catalyst material) capable of oxidizing water ($H_2O$) to produce oxygen and hydrogen ions or oxidizing hydroxide ions ($OH^-$) to produce water and oxygen, and capable of decreasing the overvoltage of such a reaction.

The anode 41 includes a base (porous base) having a structure that allows the anolyte and ions to move between the separator 50 and the anode channel 42, for example, a porous structure such as a mesh material, a punched material, or a porous sintered compact. As the anolyte, an aqueous solution containing a desired electrolyte is usable. As such an electrolytic solution, usable is an aqueous solution containing, for example, phosphate ions ($PO_4^{2-}$), borate ions ($BO_3^{3-}$), sodium ions ($Na^+$), potassium ions ($K^+$), calcium ions ($Ca^{2+}$), lithium ions ($Li^+$), cesium ions ($Cs^+$), magnesium ions ($Mg^{2+}$), chloride ions ($Cl^-$), hydrogen carbonate ions ($HCO_3^-$), carbonate ions ($CO_3^{2-}$), or the like. The separator 50 is formed of a material that allows the ions to move between the anode 41 and the cathode 31 and that is capable of separating the anode part 40 and the cathode part 30.

In the electrolysis cell stack 10 described above, the electrolytic solution may move from the anode 41 side to the cathode 31 side. The electrolytic solution which has moved to the cathode 31 side inhibits carbon dioxide from reaching a reaction site of a catalyst surface of the cathode 31 to cause the performance degradation of the electrolysis cell. Therefore, it is required to predict the performance of the electrolysis cell stack 10 in consideration of phenomena such as flooding and salt precipitation and suppress the flooding and the salt precipitation. For this purpose, by simulating the performance by computation using, as the first variable group, a variable representing at least one of flooding and salt precipitation, the simulator 100 of the embodiment is capable of simulating the performance of the electrolysis cell stack 10 under a condition close to an actual use condition.

The variable of the first variable group can be selected from the composition, mass, volume, and density of a solution or a solid in the interior of the electrolysis cell stack 10, for example, in a specific area of the anode channel 42, the anode 41, the separator 50, the cathode 31, or the cathode channel 32, their temporal and spatial variations, and those resulting from the nondimensionalization of these quantities. Further, in a cell stack including the plurality of electrolysis cells 20, the statistic (for example, the average, standard deviation, or the like) of each of the aforesaid quantities in the cells in the stack is also adoptable as the variable of the first variable group. Examples of the temporal and spatial variations include the accumulation and lost amounts of a solution or a solid in an area of interest inside the electrolysis cell, a flux exiting from/entering the aforesaid area, and so on. Examples of the nondimensionalized quantities include a ratio of a liquid occupying the volume of the cathode channel 32, and a normalized flux of a solution flowing in at a given position in the cathode 31, by a value that it has at the start of the electrolysis.

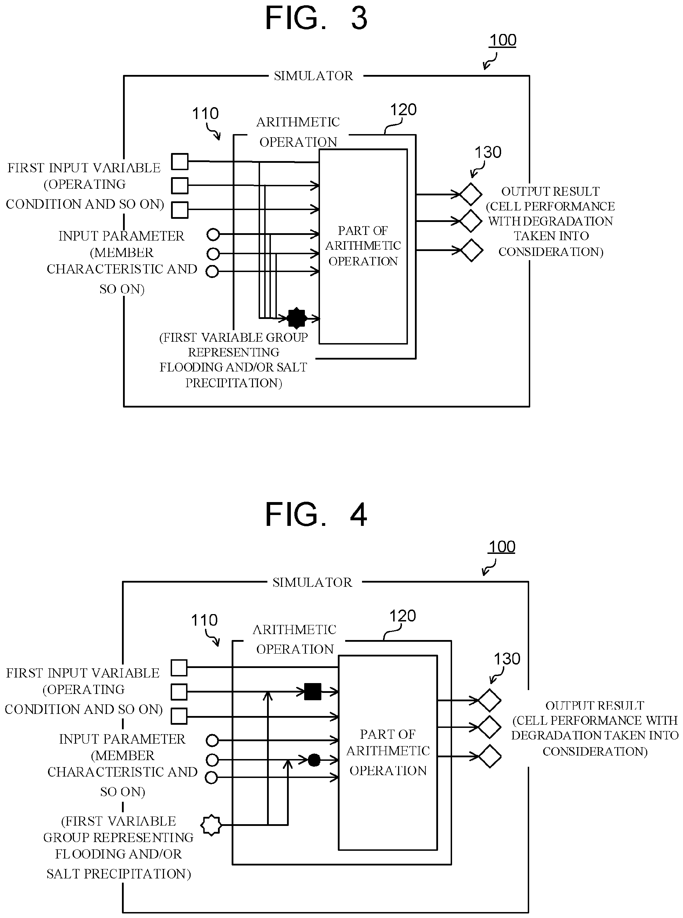

FIG. 3 is a diagram illustrating a second example of the simulator 100 of the embodiment. In the simulator 100 of the embodiment, the variable forming the first variable group may be defined as a function of another variable or a parameter. For example, the volume of the solution in the cathode channel can be defined as a function of an operating temperature, the dew point of the gas supplied to the electrolysis cell, the wettability of a channel material, or the like.

FIG. 4 is a diagram illustrating a third example of the simulator 100 of the embodiment. In the simulator 100 of the embodiment, based on the variable forming the first variable group, another variable or a model parameter may be updated. For example, based on the volume of the solution in the cathode, the porosity or exchange current density of the cathode, the local temperature of cathode reaction site, or the like can be updated. FIG. 4 illustrates a case where the other variable and the model parameter are updated based on a variable, in the first variable group, that is to be an input to the arithmetic operation (second input variable), but the other variable and the model parameter may be updated based on a variable, in the first variable group, that is computed in the model.

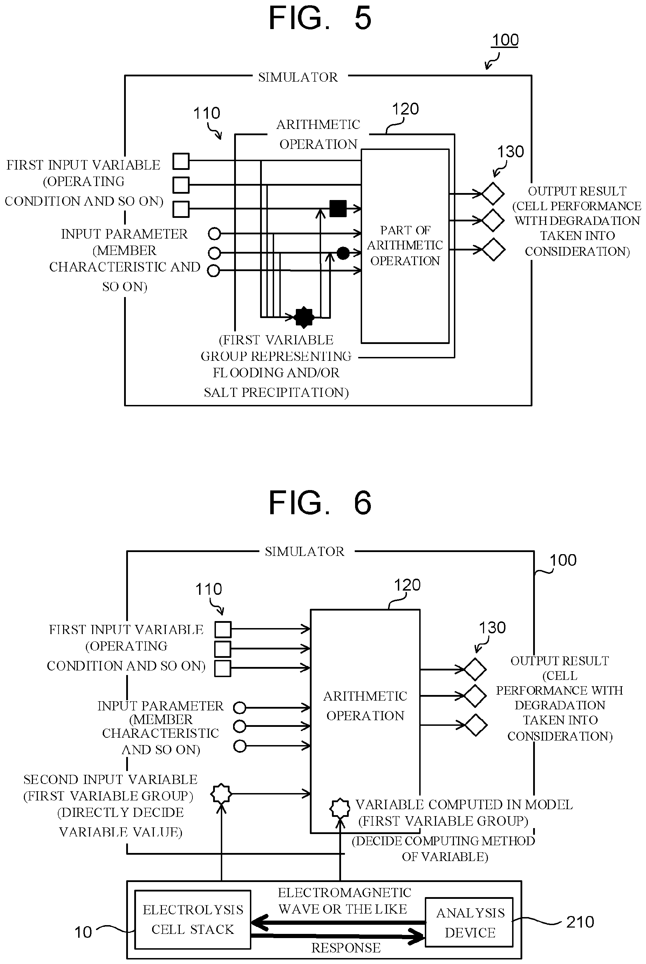

FIG. 5 is a diagram illustrating a fourth example of the simulator 100 of the embodiment. In the simulator 100 of the embodiment, a value of the first variable group calculated from a variable or a parameter may be further used for updating another variable or a parameter. At this time, the variable or the parameter updated based on the value of the first variable group may be one used or not used for the decision of the value of the first variable group.

FIG. 6 is a diagram illustrating a fifth example of the simulator 100 of the embodiment. The first variable group includes the composition, mass, volume, and density of a solution or a solid in the interior of the electrolysis cell, or their temporal and/or spatial variations. All or some of the values of the first variable group can be decided based on an analysis of the first cell stack or a second electrolysis cell stack having an equivalent characteristic to that of the first electrolysis cell stack. The variable of the first variable group or computational algorithm of the variables used in the simulator 100 illustrated in FIG. 6 is decided based on the result obtained when an analysis device 210 analyzes the first electrolysis cell stack 10 or the second electrolysis cell stack.

The analysis device 210 is configured to analyze the electrolysis cell stack 10 using at least one of an electromagnetic wave, a particle beam, an acoustic wave, an electromagnetic field, a current, and a voltage, and it analyzes the result to obtain quantitative information on the solution or the solid. At this time, a signal other than the electromagnetic wave, the particle beam, the acoustic wave, the electromagnetic field, the current, and the voltage may be used. Examples of a specific analysis method include the imaging of the inside of the electrolysis cell using an X-ray, visible light, a neutron beam, an ultrasonic wave, nuclear magnetic resonance, or the like and electrochemical impedance measurement using an alternating current and voltage. A plurality of analysis methods may be combined.

In the case where it is difficult to apply the used analysis method directly to the first electrolysis cell stack, the second electrolysis cell stack having an equivalent characteristic to that of the first electrolysis cell stack is prepared, and based on its analysis result of the second electrolysis cell stack, it is possible to configure a simulator of the first electrolysis cell stack. For example, in the case where the surface of the first electrolysis cell stack is made of metal, it is difficult to analyze the cell interior using visible light. The second electrolysis cell stack is fabricated by a method of, for example, replacing the metal component of the surface with a transparent material, and its analysis result can be used for the simulation of the first electrolysis cell stack. Similarly, in the case where the first electrolysis cell stack is made of a material strongly absorbing an X-ray, it is difficult to image the cell interior using the transmitted X-ray. In such a case, the second electrolysis cell stack may be fabricated by reducing the thickness of the component made of the material strongly absorbing the X-ray or replacing its material with a material having a low absorbance. Further, it is also possible to fabricate an easy-to-handle second electrolysis cell stack by decreasing the number of the stacked cells of the first cell stack or decreasing the electrode area.

The variable of the first variable group may be an input to the arithmetic operation or may be indirectly computed in the model from another variable. Therefore, two types of methods are conceivable as the method of using the analysis result of the first or second electrolysis cell stack. One is a method of obtaining and using the value itself of the variable representing the degree of at least one of flooding and salt precipitation. The other is a method of obtaining and using the relation of a device condition such as an operating condition or a component characteristic with the value of the first variable group. The former is applicable to the case where the analysis is directly performed while the first electrolysis cell stack is in operation, to decide the value of the first variable group and the arithmetic operation is performed based on this to predict the future performance of the first electrolysis cell stack. For example, observation with visible light or an ultrasonic wave and electrochemical impedance measurement with an alternating current and/or voltage do not require large facilities, and thus it is possible to directly perform the analysis while the electrolysis cell stack is in operation by attaching equipment involved in the analysis to the electrolysis cell stack.

The latter is a method that can be used even in the case where the analysis is not directly performed while the first electrolysis cell stack is in operation. The first or second electrolysis cell stack is analyzed in advance under various conditions, how the value of the first variable group varies according to each condition is grasped, and the relation therebetween is incorporated into the model. This makes it possible to estimate the state of flooding and/or salt precipitation only from the operating condition such as temperature, pressure, and current density, to predict the performance with flooding and/or salt precipitation taken into consideration, without performing any special analysis during the operation period when the performance is desired to be predicted. For example, an analysis using an X-ray or a neutron beam and measurement using nuclear magnetic resonance require large-scale and highly sophisticated facilities. Usually, a site where the electrolysis device is used is in an environment without such special analysis facilities. Therefore, in the case where these analyses are used, by analyzing the first or second electrolysis cell stack in advance in a specialized device or facility and incorporating the result in the model, it is possible to use the simulation of the embodiment at the site where the electrolysis device is used. The two types of use methods described above can also be used together. That is, a variable obtained from a real-time analysis and a variable computed in the model both may be used.

For the imaging experiment in which the transmitted light of the X-ray is measured, an analysis based on the Lambert-Beer's law is useful. The Lambert-Beer's law is expressed as follows.

$$A = -\log_{10}(I_{out}/I_{in}) = ECL \quad ...(1)$$

In the formula (1), A is absorbance, $I_{in}$ and $I_{out}$ are light intensities of incident light and transmitted light, E is a molar absorption coefficient, C is the molar concentration of a medium, and L is the length of the medium. Using this enables the quantification of a substance in a measurement target range. For example, a cathode channel of a carbon dioxide electrolysis cell is filled with a carbon dioxide gas at the start of electrolysis, and to quantify the amount of the liquid flowing thereto, X-ray imaging is usable.

In an experiment in which a certain position in the cathode channel is irradiated with an X-ray from a cross-sectional direction of the electrolysis cell and the intensity of the transmitted light is observed, let the intensity of the transmitted light before the start of the electrolysis (time t = 0) be $I_0$, and let the intensity of the transmitted light at a time $t_1$ during the electrolysis be In. At the time t = 0, only the gas is present in the channel, but at t = $t_1$, the liquid has moved into the channel to absorb the X-ray. Assuming that there is no precipitation of solid salt and the X-ray absorption by the gas and a variation in liquid concentration are also negligible, a difference between absorbances at the two times depends only on the volume of the liquid in the channel, and the following formula (2) holds.

$$-\log_{10}(I_{t1}/I_0) = E_{liq}C_{liq}L_{liq,\,t1} \ldots (2)$$

In the formula (2), $E_{liq}$ and $C_{liq}$ are the molar absorption coefficient and the molar concentration of the liquid respectively, $L_{liq,\,t1}$ is the length of the liquid occupying in a depth direction at the observation position of the channel cross section at the time $t_1$. From this, it is possible to find $L_{liq,\,t1}$ from $I_0$, $I_{t1}$ obtained by the measurement, and this is usable as a constituent variable of the first variable group. Further, by performing integration (or approximate product-sum computation) of $L_{liq,\,t1}$ regarding the channel cross section, it is possible to obtain the volume of the liquid occupying the channel space, and this is also usable as a constituent variable of the first variable group.

Not only the comparison between those at the time before the start of the electrolysis and the time $t_1$ during the electrolysis but also the comparison between those at the two times $t_1$ and $t_2$ during the electrolysis can be made. In this case, from the transmitted light intensities In and $I_{t2}$ at these times, a variation in the liquid volume in a period between these times can be calculated by the following formula.

$$-\log_{10}(I_{t1}/I_{t2}) = E_{liq}C_{liq}(L_{liq,\,t2} - L_{liq,\,t1}) \ldots (3)$$

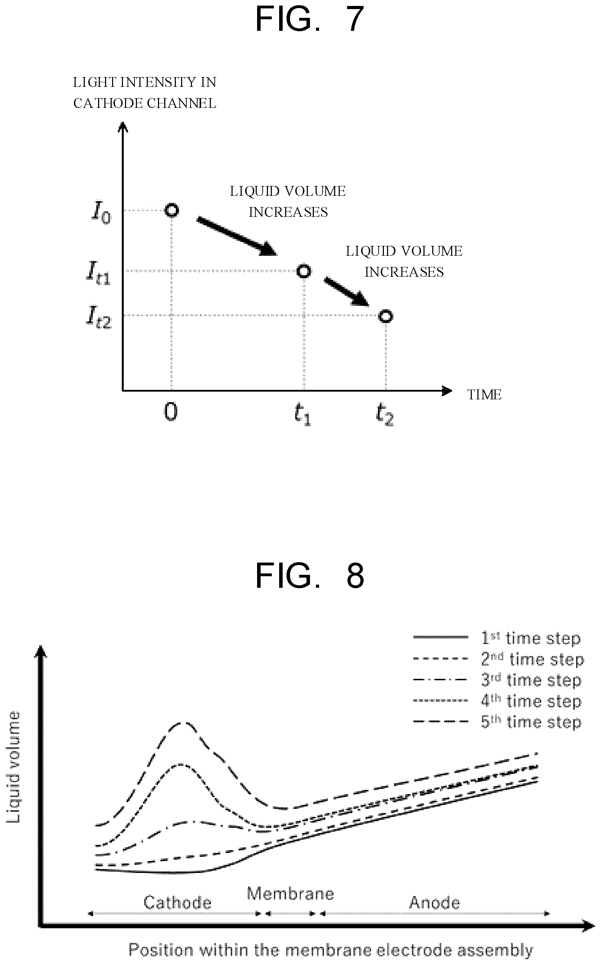

Dividing the variation in the liquid volume by time can give a change rate of the liquid volume. These may be used as constituent variables of the first variable group. FIG. 7 schematically illustrates a temporal variation in the light intensity in the cathode channel.

FIG. 8 is an example of an analysis of the result of X-ray imaging of a cross section of the electrolysis cell including the cathode, the membrane, and the anode. FIG. 8 illustrates a temporal variation in the liquid volume which is calculated at positions based on the result of the X-ray transmitted light intensity measurement. In the case where the liquid volume in the first electrolysis cell stack is defined as the first variable group, it is possible to grasp spatial and temporal variations of the variable based on such data.

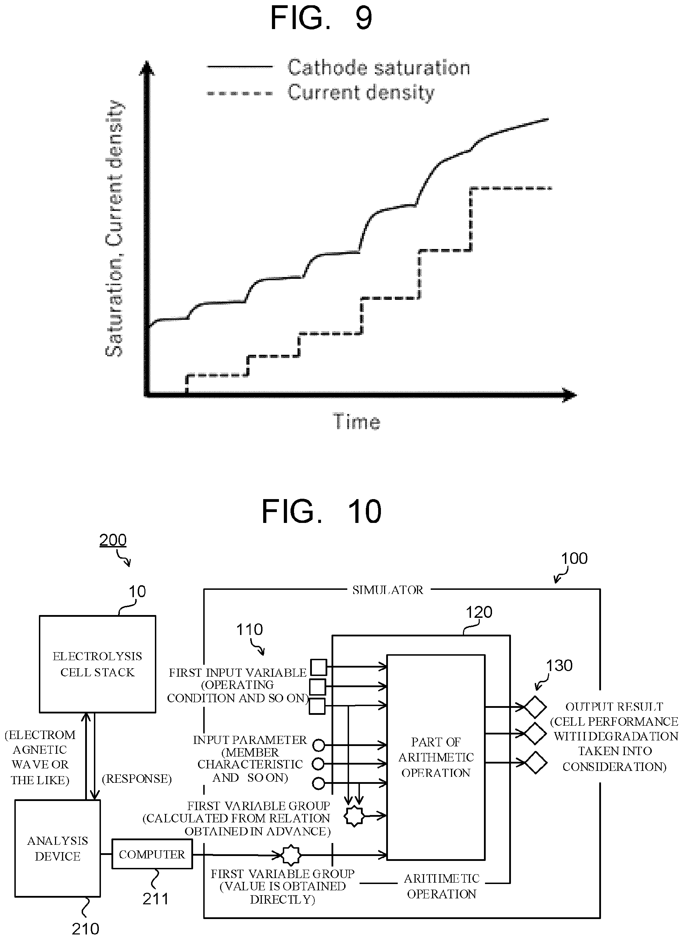

FIG. 9 is an example of an analysis of the result of the X-ray imaging of a cathode cross section under a varied current density applied to the electrolysis cell. The liquid volume present in a range of interest of the cathode is calculated based on the result of the X-ray transmitted light intensity measurement, and in FIG. 9, a ratio of the liquid occupying the volume of this range is defined as saturation. Based on such data, it is possible to find the dependence of the first variable group on current density and current application time.

As a conventional simulation that simulates the performance of an electrolysis cell stack, many simulations for finding the performance at a steady state on the premise that the operation is performed stably have been known. In such simulations, time need not be handled as a variable in computation. On the other hand, a simulation with degradation taken into consideration is expected to enable the prediction of the future performance of the electrolysis cell stack. Therefore, the simulation model of the embodiment may consider time as a variable regarding an input, an arithmetic operation, and an output. In particular, the first variable group representing at least one of flooding and salt precipitation may be dependent on time.

For example, there is a phenomenon that flooding progresses during operation under a given current density and a ratio of a liquid phase occupying the cathode catalyst layer increases with time. To perform computation simulating this, there is a method of defining a liquid volume at respective times or its increase rate as the first variable group. As a value of the first variable group varies, a performance value such as a voltage value or selectivity of a product, which is obtained as the result of the computation, also varies with time. This makes it possible to predict the performance at a time later than the time of interest. Based on information on the operating condition or cell performance during a period from the start of the operation of the electrolysis cell stack up to a given time, it is also possible to create a statistical model that predicts the performance that the electrolysis cell stack is to have at a later time than this period. According to the embodiment, it is possible to incorporate the first variable group representing at least one of flooding and salt precipitation into such a model. For example, in the case where a machine learning model that receives information obtained during a given past period including the time of interest and outputs the performance that the electrolysis cell is to have at a given time later than this time is configured, it is possible to enhance prediction accuracy by including the first variable group in the input.

It is possible to accomplish an electrolysis device including the simulator described in any of the above examples and the first electrolysis cell stack. The electrolysis device may include a constituent element other than the simulator and the first electrolysis cell stack. For example, it may include an analysis device that analyzes the first electrolysis cell stack and a computer that analyzes the analysis result. FIG. 10 illustrates an example of the electrolysis device of the embodiment. An electrolysis device 200 illustrated in FIG. 10 includes a first electrolysis cell stack 10, an analysis device 210 that analyzes the first electrolysis cell stack, and a computer 211 that analyzes the analysis result of the analysis device 210.

Since observation with visible light, an ultrasonic wave, or the like and electrochemical impedance measurement with an alternating current and/or voltage can be done relatively easily, by attaching equipment involved in such analyses (the analysis device 210 and the computer 211) to the first electrolysis cell stack 10, it is possible to directly perform the analysis during the operation of the first electrolysis cell stack 10. On the other hand, in the case where X-ray imaging, neutron beam imaging, nuclear magnetic resonance imaging method, or the like requiring large-scale facilities is used, it is desirable to execute the analysis in advance under various operating conditions and component conditions, grasp the correspondence between these conditions and the value of the first variable group, and incorporate it into the computational algorithm of the simulator.

In the electrolysis device of the embodiment, by providing detectors in the first electrolysis cell stack and auxiliary equipment or the like for driving the first electrolysis cell stack, inputting data obtained using the detectors the simulator and executing computation using the input, it is possible to control the operation of the first electrolysis cell stack using the contents of the computation. Examples of the auxiliary equipment or the like include a power source, a pump, a heater, and a pipe, but it is not limited to any of these. Examples of the detector include a thermometer, a pressure gauge, a dew-point meter, an ammeter, a voltmeter, a gas flowmeter, and a gas composition analyzer, but it is not limited to any of these.

It is possible to control the operating condition of the first electrolysis cell stack, using at least one value included in the computation in the simulator. Here, the value included in the computation refers to at least one selected from an input value to the simulation model, a value of the variable defined in the computation, and a value obtained as the output result. These values may be variables included in the first variable group or may be variables not included in the first variable group. Usable examples of these include a present pressure in the first electrolysis cell stack input to the model, a present or future assumed liquid volume in the cell calculated in the computation based on the operating condition or the component characteristic, and future product selectivity or cell voltage obtained as the output of the computation.

In controlling the first electrolysis cell stack, an arithmetic unit and a control unit are provided in the electrolysis device, and these are used. The arithmetic unit is a computer that receives at least one value included in the computation in the simulator and based on this, determines an operating condition under which degradation is suppressed. The arithmetic unit may be a computer separate from the simulator of the above-described embodiment, or an additional computing function implemented in the simulator of the embodiment may serve as the arithmetic unit. The computational algorithm implemented in the arithmetic unit may be one using an analytic equation, may be one using a numerical solution, or may be one using machine learning. Examples of the contents of the determination of the operating condition by the arithmetic unit include raising the dew point of the supply gas in response to a pressure increase in the cell, thereby reducing salt precipitation, or changing an inter-electrode differential pressure in response to an increase in an assumed liquid volume in the cell, thereby reducing flooding. The control unit is a part for sending a signal to the first electrolysis stack and the auxiliary equipment or the like to achieve the operating condition obtained as a result of the computation by the arithmetic unit.

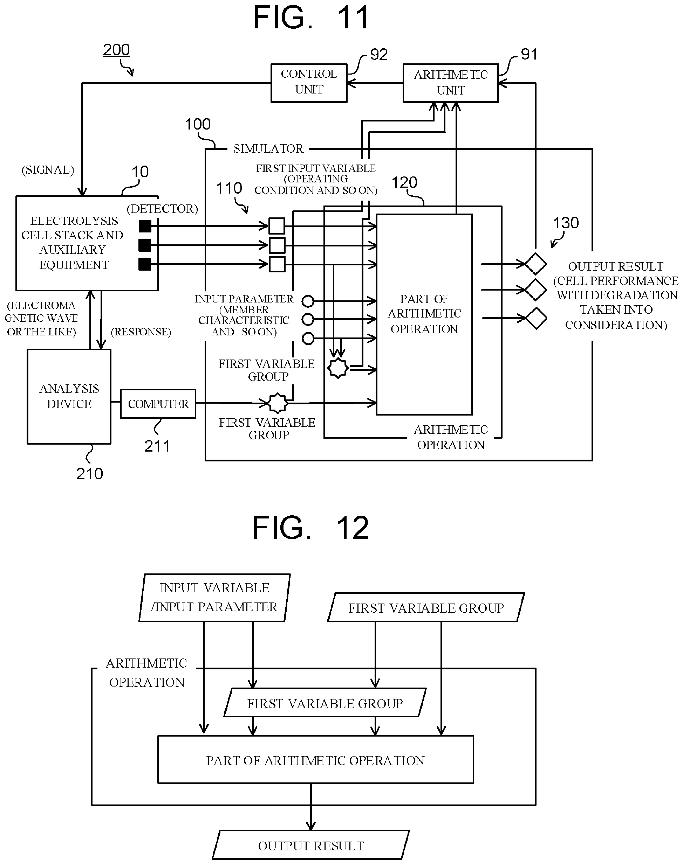

FIG. 11 illustrates another example of the electrolysis device of the embodiment.

An electrolysis device 200 illustrated in FIG. 11 includes an arithmetic unit 91 and a control unit 92 in addition to the configuration of the electrolysis device 200 illustrated in FIG. 10. Further, the first electrolysis cell stack 10 includes auxiliary equipment such as detectors. In the case where such an electrolysis device 200 includes an analysis device 210 that directly analyzes the first electrolysis cell stack 10 and a computer 211 that analyzes the analysis result thereof, a value of the first variable group obtained in real time while the first electrolysis cell stack 10 is in operation can also be used for the determination by the arithmetic unit 91.

The embodiment also provides a simulation model (computational algorithm) that can be implemented in the simulator. The model is composed of an input, an arithmetic operation, and an output. The arithmetic operation may be, in particular, one using an analytic equation, may be one using a numerical solution, or may be one using machine learning. It may also be a multiphysics model in which computations of material balance or energy balance, a chemical reaction rate, and overvoltage are coupled. These arithmetic operations may involve convergence computation.

The computational algorithm of the embodiment uses the first variable group representing at least one of flooding and salt precipitation. As illustrated in FIG. 12, the first variable group is composed of one variable or more. These variables of the first variable group may be inputs to the arithmetic operation or may be those indirectly computed from another variable in the arithmetic operation. The variable of the first variable group can be selected from the composition, mass, volume, and density of a solution or a solid in a specific area inside the first electrolysis cell stack, their temporal and/or spatial variations, and those resulting from the nondimensionalization of these quantities. Further, in a stack including a plurality of electrolysis cells, the statistic of any of the aforesaid quantities in the electrolysis cells in the stack can also be adopted as the variable of the first variable group.

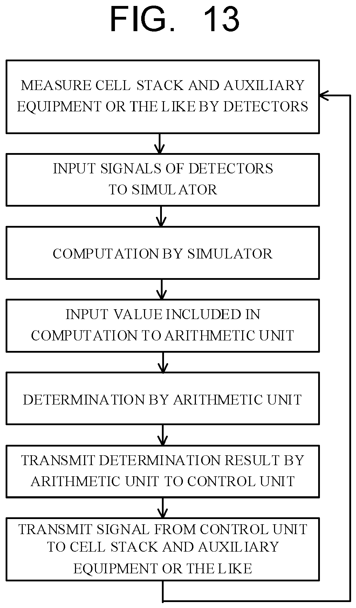

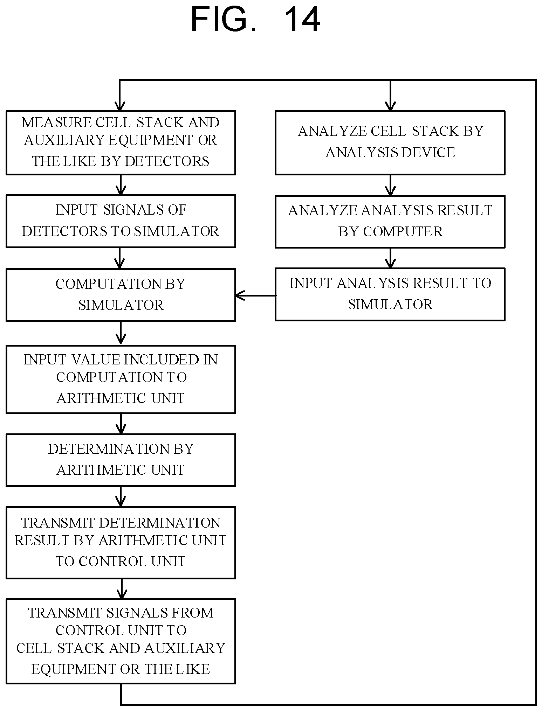

The embodiment also provides a control method of the electrolysis device. The control method follows the flows illustrated in FIG. 13 or FIG. 14, for instance. In the case where the electrolysis device does not include the analysis device or the like, the control method follows the flowchart illustrated in FIG. 13, for instance. In the case where the electrolysis device includes the analysis device and the computer that analyzes the analysis result, the control method follows the flowchart illustrated in FIG. 14, for instance.

The simulation executed by a large computer may be replaced with an approximate model, for example, a linear or nonlinear model or the like. It is expected that thus simplifying the simulation makes it possible to obtain, in a shorter time, the computation result approximately on the same level as that of a simulation for which even a large computer requires a somewhat long computation time. Further, implementing the simplified model in an edge device or the like such as a microcomputer makes it possible for a small device to output the result of the computation simulating the simulation. Further, the simulation may be simplified by preparing the results of the simulation of a combination of many parameters and extracting the weight of a machine learning regression model that has learned these results. For example, mounting the weight on an edge device such as a microcomputer makes it possible for a small device to output the computation simulating the simulation.

In the case where a central processing unit characterized by low power consumption, a small number of clocks, and a small number of computing elements, which is mounted on the edge device, performs the computation using the aforesaid simplified model, it is expected that the computation result on substantially the same level as that of simulation by a large computer can be obtained for the same input in a shorter time. Inputting outputs of a sensor group of the electrolysis device to such an edge device makes it possible to compute the computation result with a shorter delay as compared with a simulation by a large-scale computer. Consequently, a control signal that is to be returned based on the input from the electrolysis device can be sent quickly, making it possible to obtain a higher-performance electrolysis device.

In the above-described embodiment, the simulator of the embodiment which is applied to the $CO_2$ electrolysis device and such a $CO_2$ electrolysis device have been mainly described as the examples, but the simulator of the embodiment may be applied to an electrolysis device other than the $CO_2$ electrolysis device, and the embodiment further includes such an electrolysis device. Examples of the electrolysis device other than the $CO_2$ electrolysis device include an $H_2O$ electrolysis device that electrolyzes water ($H_2O$) to produce hydrogen and oxygen and an $N_2$ electrolysis device that electrolyzes nitrogen ($N_2$) to produce ammonia ($NH_3$) and other nitrogen-containing species, but it is not limited to any of these.

It should be noted that the configurations of the above-described embodiments may be employed in combination, and they may be partly replaced. While certain embodiments of the present invention have been described here, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

**Claims**

1. An electrolysis device simulator comprising:

   an arithmetic unit configured to simulate, by computation, performance of a first electrolysis cell stack including one or more electrolysis cells each including a cathode configured to perform a reduction reaction and an anode configured to perform an oxidation reaction, wherein
   the arithmetic unit is configured to perform an arithmetic operation using a first variable group representing at least one of flooding and salt precipitation in the first electrolysis cell stack.

2. The simulator according to claim 1,

   wherein the first variable group includes a variable expressed as a function of another variable or a parameter in algorithm of the computation, and
   wherein the arithmetic unit is configured to perform the arithmetic operation using the first variable group including the variable.

3. The simulator according to claim 1, wherein the arithmetic unit is configured to perform the arithmetic operation using another variable or a parameter updated according to a value of the first variable group.

4. The simulator according to any one of claim 1 to claim 3,

   wherein a value of the first variable group is decided based on a result obtained when the first electrolysis cell stack or a second electrolysis cell stack having an equivalent characteristic to that of the first electrolysis cell stack is analyzed using at least one of an electromagnetic wave, a particle beam, an acoustic wave, an electromagnetic field, a current, and a voltage, and
wherein the arithmetic unit is configured to perform the arithmetic operation using the first variable group decided based on the result of the analysis.

5. The simulator according to claim 4, wherein the analysis is an imaging experiment that visualizes a state of an interior of the first or second electrolysis cell stack.

6. The simulator according to claim 5,

wherein the value of the first variable group is decided based on a result obtained when the result of the imaging experiment is analyzed based on the Lambert-Beer's law, and
wherein the arithmetic unit is configured to perform the arithmetic operation using the first variable group decided based on the result of the analysis.

7. The simulator according to claim 6,

wherein the value of the first variable group is found from absorbance obtained in the analysis, and
wherein the arithmetic unit is configured to perform the arithmetic operation using the first variable group found from the absorbance.

8. The simulator according to any one of claim 1 to claim 7,

wherein the first variable group includes a variable dependent on time, and
wherein the arithmetic unit is configured to perform the arithmetic operation using the first variable group including the variable dependent on the time.

9. An electrolysis device simulation method which simulates, by computation, performance of a first electrolysis cell stack including one or more electrolysis cells each including a cathode configured to perform a reduction reaction and an anode configured to perform an oxidation reaction,
wherein, in algorithm of the computation, a first variable group representing at least one of flooding and salt precipitation in the first electrolysis cell stack is used.

10. The simulation method according to claim 9, wherein the first variable group includes a variable expressed as a function of another variable or a parameter in the algorithm of the computation.

11. The simulation method according to claim 9 or claim 10, wherein a value of the first variable group is decided based on a result obtained when the first electrolysis cell stack or a second electrolysis cell stack having an equivalent characteristic to that of the first electrolysis cell stack is analyzed using at least one of an electromagnetic wave, a particle beam, an acoustic wave, an electromagnetic field, a current, and a voltage.

12. The simulation method according to claim 11, wherein the analysis is an imaging experiment that visualizes a state of an interior of the first or second electrolysis cell stack.

13. The simulation method according to claim 12, wherein, in deciding the value of the first variable group, the result of the imaging experiment is analyzed based on the Lambert-Beer's law.

14. The simulation method according to any one of claim 9 to claim 13, wherein the first variable group includes a variable dependent on time.

15. An electrolysis device comprising:

the simulator according to any one of claim 1 to claim 8; and
the first electrolysis cell stack.

# FIG. 1

SIMULATOR (COMPUTER)

100

110

120

130

FIRST INPUT VARIABLE
(OPERATING CONDITION
AND SO ON)

INPUT PARAMETER
(MEMBER CHARACTERISTIC
AND SO ON)

ARITHMETIC
OPERATION

SECOND INPUT VARIABLE
(FIRST VARIABLE GROUP
REPRESENTING FLOODING
AND/OR SALT
PRECIPITATION)

OUTPUT RESULT
(CELL PERFORMANCE WITH
DEGRADATION TAKEN INTO
CONSIDERATION)

VARIABLE COMPUTED IN MODEL
(FIRST VARIABLE GROUP
REPRESENTING FLOODING AND/OR
SALT PRECIPITATION)

# FIG. 2

# FIG. 3

SIMULATOR

100

110

ARITHMETIC OPERATION

120

130

FIRST INPUT VARIABLE (OPERATING CONDITION AND SO ON)

INPUT PARAMETER (MEMBER CHARACTERISTIC AND SO ON)

PART OF ARITHMETIC OPERATION

OUTPUT RESULT (CELL PERFORMANCE WITH DEGRADATION TAKEN INTO CONSIDERATION)

(FIRST VARIABLE GROUP REPRESENTING FLOODING AND/OR SALT PRECIPITATION)

# FIG. 4

SIMULATOR

100

110

ARITHMETIC OPERATION

120

130

FIRST INPUT VARIABLE (OPERATING CONDITION AND SO ON)

INPUT PARAMETER (MEMBER CHARACTERISTIC AND SO ON)

PART OF ARITHMETIC OPERATION

OUTPUT RESULT (CELL PERFORMANCE WITH DEGRADATION TAKEN INTO CONSIDERATION)

(FIRST VARIABLE GROUP REPRESENTING FLOODING AND/OR SALT PRECIPITATION)

# FIG. 5

SIMULATOR

100

110

ARITHMETIC
OPERATION

120

130

FIRST INPUT VARIABLE
(OPERATING
CONDITION AND SO ON)

INPUT PARAMETER
(MEMBER
CHARACTERISTIC AND
SO ON)

PART OF
ARITHMETIC
OPERATION

OUTPUT RESULT
(CELL PERFORMANCE
WITH DEGRADATION
TAKEN INTO
CONSIDERATION)

(FIRST VARIABLE
GROUP REPRESENTING
FLOODING AND/OR
SALT PRECIPITATION)

# FIG. 6

SIMULATOR

100

110

120

130

FIRST INPUT VARIABLE
(OPERATING
CONDITION AND SO ON)

INPUT PARAMETER
(MEMBER
CHARACTERISTIC
AND SO ON)

ARITHMETIC
OPERATION

OUTPUT RESULT
(CELL
PERFORMANCE WITH
DEGRADATION
TAKEN INTO
CONSIDERATION)

SECOND INPUT VARIABLE
(FIRST VARIABLE GROUP)
(DIRECTLY DECIDE
VARIABLE VALUE)

VARIABLE COMPUTED IN MODEL
(FIRST VARIABLE GROUP)
(DECIDE COMPUTING METHOD
OF VARIABLE)

ELECTROLYSIS
CELL STACK

ELECTROMAGNETIC
WAVE OR THE LIKE

RESPONSE

ANALYSIS
DEVICE

10

210

# FIG. 7

LIGHT INTENSITY IN
CATHODE CHANNEL

$I_0$

LIQUID VOLUME
INCREASES

$I_{t1}$

LIQUID VOLUME
INCREASES

$I_{t2}$

TIME

0            $t_1$            $t_2$

# FIG. 8

1st time step
2nd time step
3rd time step
4th time step
5th time step

Liquid volume

Cathode        Membrane        Anode

Position within the membrane electrode assembly

# FIG. 9

# FIG. 10

# FIG. 11

200

92 CONTROL UNIT

91 ARITHMETIC UNIT

100 SIMULATOR

FIRST INPUT VARIABLE (OPERATING CONDITION AND SO ON)

110

120

130

(SIGNAL)

10 (DETECTOR)

ELECTROLYSIS CELL STACK AND AUXILIARY EQUIPMENT

(ELECTROMAGNETIC WAVE OR THE LIKE)

(RESPONSE)

INPUT PARAMETER (MEMBER CHARACTERISTIC AND SO ON)

PART OF ARITHMETIC OPERATION

OUTPUT RESULT (CELL PERFORMANCE WITH DEGRADATION TAKEN INTO CONSIDERATION)

FIRST VARIABLE GROUP

ANALYSIS DEVICE

COMPUTER

FIRST VARIABLE GROUP

ARITHMETIC OPERATION

211

210

# FIG. 12

INPUT VARIABLE /INPUT PARAMETER

FIRST VARIABLE GROUP

ARITHMETIC OPERATION

FIRST VARIABLE GROUP

PART OF ARITHMETIC OPERATION

OUTPUT RESULT

# FIG. 13

```
┌─────────────────────────────────────────┐
│  MEASURE CELL STACK AND AUXILIARY        │◄──┐
│  EQUIPMENT OR THE LIKE BY DETECTORS      │   │
└─────────────────────────────────────────┘   │
                    │                           │
                    ▼                           │
┌─────────────────────────────────────────┐   │
│       INPUT SIGNALS OF DETECTORS         │   │
│            TO SIMULATOR                   │   │
└─────────────────────────────────────────┘   │
                    │                           │
                    ▼                           │
┌─────────────────────────────────────────┐   │
│       COMPUTATION BY SIMULATOR           │   │
└─────────────────────────────────────────┘   │
                    │                           │
                    ▼                           │
┌─────────────────────────────────────────┐   │
│       INPUT VALUE INCLUDED IN            │   │
│   COMPUTATION TO ARITHMETIC UNIT         │   │
└─────────────────────────────────────────┘   │
                    │                           │
                    ▼                           │
┌─────────────────────────────────────────┐   │
│    DETERMINATION BY ARITHMETIC UNIT      │   │
└─────────────────────────────────────────┘   │
                    │                           │
                    ▼                           │
┌─────────────────────────────────────────┐   │
│   TRANSMIT DETERMINATION RESULT BY       │   │
│   ARITHMETIC UNIT TO CONTROL UNIT        │   │
└─────────────────────────────────────────┘   │
                    │                           │
                    ▼                           │
┌─────────────────────────────────────────┐   │
│  TRANSMIT SIGNAL FROM CONTROL UNIT       │   │
│   TO CELL STACK AND AUXILIARY            │   │
│       EQUIPMENT OR THE LIKE              │   │
└─────────────────────────────────────────┘   │
                    │                           │
                    └───────────────────────────┘
```

# FIG. 14

```
┌─────────────────────────┐      ┌─────────────────────────┐
│ MEASURE CELL STACK AND  │      │  ANALYZE CELL STACK BY  │
│ AUXILIARY EQUIPMENT OR  │      │    ANALYSIS DEVICE      │
│ THE LIKE BY DETECTORS   │      └─────────────────────────┘
└─────────────────────────┘                  │
            │                                 ▼
            ▼                      ┌─────────────────────────┐
┌─────────────────────────┐      │  ANALYZE ANALYSIS RESULT │
│    INPUT SIGNALS OF     │      │      BY COMPUTER        │
│ DETECTORS TO SIMULATOR  │      └─────────────────────────┘
└─────────────────────────┘                  │
            │                                 ▼
            ▼                      ┌─────────────────────────┐
┌─────────────────────────┐      │  INPUT ANALYSIS RESULT TO│
│    COMPUTATION BY       │◄──── │       SIMULATOR          │
│      SIMULATOR          │      └─────────────────────────┘
└─────────────────────────┘
            │
            ▼
┌─────────────────────────┐
│ INPUT VALUE INCLUDED IN │
│   COMPUTATION TO        │
│   ARITHMETIC UNIT       │
└─────────────────────────┘
            │
            ▼
┌─────────────────────────┐
│   DETERMINATION BY      │
│    ARITHMETIC UNIT      │
└─────────────────────────┘
            │
            ▼
┌─────────────────────────┐
│ TRANSMIT DETERMINATION  │
│ RESULT BY ARITHMETIC UNIT│
│    TO CONTROL UNIT      │
└─────────────────────────┘
            │
            ▼
┌─────────────────────────┐
│ TRANSMIT SIGNALS FROM   │
│    CONTROL UNIT TO      │
│ CELL STACK AND AUXILIARY│
│ EQUIPMENT OR THE LIKE   │
└─────────────────────────┘
```